# EUROPÄISCHE PATENTSCHRIFT

(11) **EP 1 202 332 B1**
(45) Veröffentlichungstag und Bekanntmachung des Hinweises auf die Patenterteilung: **31.10.2007**
(21) Anmeldenummer: 01121388.1
(22) Anmeldetag: 06.09.2001
(51) Int. Cl.: H01L 21/28, H01L 21/768, H01L 21/02, H01L 21/8246, H01L 27/115

(54) **Kontaktierungsstruktur für einen ferroelektrischen Speicherkondensator und Verfahren zu ihrer Herstellung**
Contact structure for a ferroelectric capacitor and method of manufacturing
Structure de contact pour un condensateur ferro-électrique et procédé de sa fabrication

(30) Priorität: 26.10.2000 DE 10053172
(43) Veröffentlichungstag der Anmeldung: 02.05.2002
(73) Patentinhaber: Qimonda AG, 81739 München (DE)
(72) Erfinder: Sitaram, Arkalgud, Fishkill, NY 12524 (US); Dehm, Christine, 90403 Nürnberg (DE); Mazure-Espejo, Carlos, 38330 St. Nazaire les Eymes (FR)
(74) Vertreter: Graf Lambsdorff, Matthias

(56) Entgegenhaltungen:
- EP-A- 0 991 117
- WO-A-00/14796
- KUAH SHAOHONG ET AL: "Interaction of Ir and IrO2 thin films with polysilicon, W and WSIx" PROCEEDINGS OF THE 1997 9TH INTERNATIONAL SYMPOSIUM ON INTEGRATED FERROELECTRICS. PART 1 (OF 2);SANTA FE, NM, USA MAR 3-5 1997, Bd. 17, Nr. 1-4 part 1, 1997, Seiten 479-488, XP008027602 Integr Ferroelectr;Integrated Ferroelectrics 1997 Gordon & Breach Science Publ Inc, Newark, NJ, USA
- SONG Y J ET AL: "A novel diffusion barrier using oxygen stopping layer for high density FRAM" 12TH INTERNATIONAL SYMPOSIUM ON INTEGRATED FERROELECTRICS;AACHEN, GERMANY MAR 12-15 2000, Bd. 31, Nr. 1-4, 2000, Seiten 667/351-674/358, XP008027687 Integr Ferroelectr;Integrated Ferroelectrics 2000

## Beschreibung

Die Erfindung betrifft generell das Gebiet der ferroelektrischen oder paraelektrischen Speicherkondensatoren. Insbesondere bezieht sich die Erfindung auf eine Kontaktierungsstruktur für einen derartigen ferroelektrischen oder paraelektrischen Speicherkondensator und ein Verfahren zu ihrer Herstellung.

Die in der Mikroelektronik hergestellten dynamischen Halbleiterspeicher-Bauelemente (DRAMs) bestehen im wesentlichen aus einem Auswahl- oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätskonstante von maximal etwa 8 aufweisen. Zur Verkleinerung des Speicherkondensators sowie zur Herstellung von nicht-flüchtigen Speichern werden "neuartige" Kondensatormaterialien, wie beispielsweise ferroelektrische oder paraelektrische Materialien mit deutlich höheren Dielektrizitätskonstanten, benötigt. Ein paar dieser Materialien sind in der Publikation "Neue Dielektrika für Gbit-Speicherchips" von W. Hönlein, Phys. B1. 55 (1999), genannt. Zur Herstellung von ferroelektrischen Kondensatoren für Anwendungen in derartigen nicht-flüchtigen Halbleiterspeicher-Bauelementen hoher Integrationsdichte können z.B. ferroelektrische Materialien, wie SrBi₂ (Ta, Nb)₂O₉ (SBT oder SBTN), Pb (Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (BaSr) TiO₃ (BST), zum Einsatz kommen. Wenn im folgenden von ferroelektrischen Materialien die Rede sein wird, so sollen hiervon gleichermaßen paraelektrische Materialien umfaßt sein.

Die Verwendung ferroelektrischer Materialien für Speicherkondensatoren stellt die Halbleiterprozeßtechnologie vor neue Herausforderungen. Zunächst lassen sich diese neuartigen Materialien nämlich nicht mehr mit dem traditionellen Elektrodenmaterial Polysilizium kombinieren. Der Grund hierfür liegt darin, daß nach dem Abscheiden des ferroelektrischen Materials dieses in einer sauerstoffhaltigen Atmosphäre bei Temperaturen von etwa 550 - 800°C gegebenenfalls mehrfach getempert ("konditioniert") werden muß. Zur Vermeidung von unerwünschten chemischen Reaktionen des ferroelektrischen Materials mit den Elektroden müssen ausreichend temperaturstabile und inerte Elektrodenmaterialien, wie beispielsweise Platinmetalle, d.h. Pt, Pd, Ir, Rh, Ru oder Os, deren leitfähige Oxide (z.B. RuO₂) oder andere leitfähige Oxide wie LaSrCoOx oder SrRuO₃ eingesetzt werden.

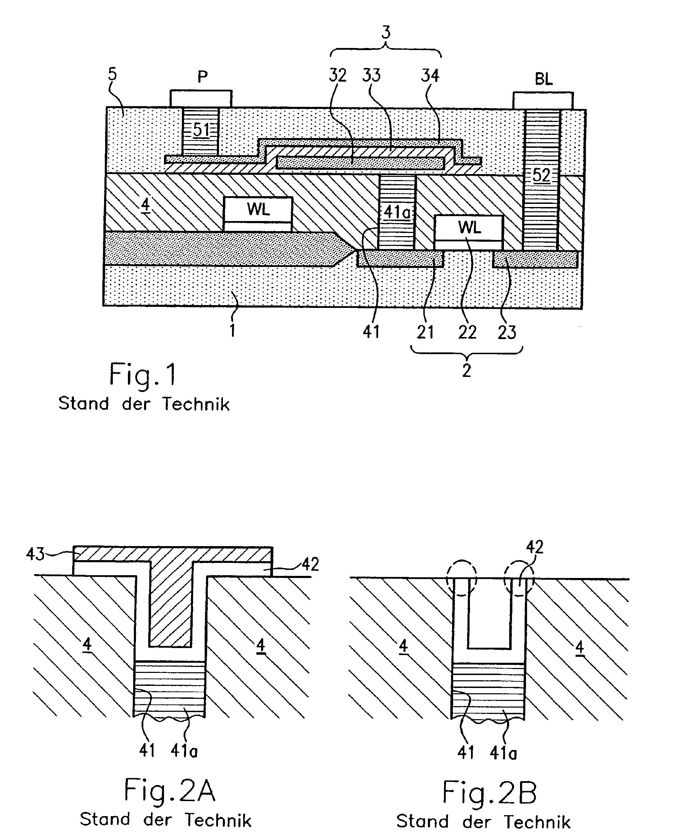

In der Fig.1 ist eine Querschnittsansicht einer konventionellen DRAM-Speicherzelle nach dem Konzept der gestapelten Zelle ("stacked cell") schematisch dargestellt. Bei diesem Aufbau der Speicherzelle sind der Schalttransistor 2 und der Speicherkondensator 3 im wesentlichen direkt übereinander angeordnet, wobei die untere Elektrode 32 des Speicherkondensators 3 mit dem Drain-Gebiet 21 des MOS-Transistors 2 durch einen mit einem Füllstopfen 41a ("plug") aus elektrisch leitfähigem Material (z.B. polykristallines Silizium) gefüllten und durch eine Isolationsschicht 4 geätzten Durchgangskontakt 41 elektrisch miteinander verbunden ist.

Auf einem Halbleitersubstrat 1 wird zunächst ein MOS-Transistor 2 dadurch hergestellt, indem durch Dotierung ein Drain-Gebiet 21 und ein Source-Gebiet 23 gebildet werden, zwischen denen ein Kanal besteht, der durch ein über dem Kanal angeordnetes Gate 22 in seiner Leitfähigkeit gesteuert werden kann. Das Gate 22 kann durch eine Wortleitung WL des Speicherbauelements gebildet oder mit dieser verbunden sein. Das Source-Gebiet 23 ist mit einer Bitleitung BL des Speicherbauelements verbunden. Der MOS-Transistor 2 wird anschließend mit einer planarisierenden Isolationsschicht 4, beispielsweise mit einem Oxid, wie SiO₂, bedeckt. Auf dieser Isolationsschicht 4 wird ein Speicherkondensator 3 geformt, indem zuerst eine untere Elektrode 32 aufgebracht und strukturiert wird, welche mit dem Drain-Gebiet 21 des MOS-Transistors 2 durch den mit dem Füllstopfen 41a gefüllten Durchgangskontakt 41 elektrisch verbunden ist. Auf die untere Elektrode 32 wird dann eine metalloxidhaltige Schicht 33 eines ferroelektrischen Materials abgeschieden, welche das Kondensatormaterial bildet. Auf diese Schicht 33 wird eine obere Elektrode 34 ganzflächig abgeschieden und strukturiert. Die erhaltene Struktur wird schließlich wiederum von einer zweiten planarisierenden Isolationsschicht 5, beispielsweise einer Oxidschicht, wie SiO₂, bedeckt. In diese wird ein weiteres Kontaktloch 51 geformt, durch das die obere Elektrode 34 des Speicherkondensators 3 mittels eines geeigneten leitfähigen Materials mit einem äußeren elektrischen Anschluß P (gemeinsame Kondensatorplatte) verbunden werden kann. Das Source-Gebiet 23 des MOS-Transistors 2 wird dadurch mit der Bitleitung BL verbunden, indem ein sich durch beide Isolationsschichten 4 und 5 erstreckendes Kontaktloch 52 gebildet und mit einem leitfähigen Material, wie polykristallinem Silizium, gefüllt wird.

In Fig.2A,B ist die konventionelle Herstellung einer Kontaktierungsstruktur im Querschnitt dargestellt. Der Durchgangskontakt 41 wird nur bis zu einer bestimmten Höhe mit dem Füllstopfen 41a gefüllt, d.h. das leitfähige Material wird zunächst bis zum Rand des Durchgangskontakts 41 in diesen abgeschieden und dann ein oberer Bereich wieder weggeätzt. Dann wird die Innenwand des somit freigelegten Abschnitts des Durchgangskontakts 41 mit einer Ti- oder TiN-Schicht 42 ausgekleidet, wobei diese ebenfalls einen Randabschnitt beidseits des Durchgangskontakts 41 auf der Oberfläche der Isolationsschicht 4 bedeckt. Auf die Ti-Schicht 42 wird dann eine Sauerstoffbarrierenschicht 43, beispielsweise aus Ir oder IrO abgeschieden. Diese Schicht soll verhindern, daß während der Herstellung bei einer thermischen Oxidation oder dergleichen Sauerstoff bis zu dem polykristallinen Silizium vordringt und an der Oberfläche eine elektrisch isolierende SiO₂-Schicht bildet. Iridium (Ir) oder Iridiumoxid (IrO) hat den Vorteil, daß es Sauerstoff absorbieren kann, ohne seine elektrische Leitfähigkeit nennenswert einzubüßen. Die darunterliegende Ti-Schicht 42 dient als geeignete Übergangsschicht, da sie einerseits mit dem polykristallinen Silizium eine niederohmige Titansilizid-Grenzschicht bildet und andererseits eine geeignete Nukleationsschicht für die Ir-Schicht 43 darstellt. Die Schichten 42 und 43 können im Prinzip auch aus anderen Materialien gebildet sein, die jedoch in jedem Fall elektrisch leitfähig sein müssen, um einen elektrischen Kontakt zu der unteren Elektrodenschicht 31 des Speicherkondensators 3 herzustellen.

Zumeist wird - wie in Fig.2B gezeigt - die sich lateral auf Randabschnitten des Durchgangskontakts 41 auf der Isolationsschicht 4 erstreckenden Abschnitte der Schichten 42 und 43 durch einen CMP-Prozeß entfernt.

Auf diese Struktur wird dann die untere Elektrodenschicht 32 beispielsweise aus Pt geformt und auf diese die ferroelektrische Schicht 33 wie beispielsweise eine SBT-Schicht aufgebracht. Der anschließende Temperaturbehandlungsschritt wird in sauerstoffhaltiger Atmosphäre durchgeführt. Dieser Prozeß basiert darauf, daß Sauerstoff aus der umgebenden Atmosphäre in die SBT-Schicht 33 eindringt und dort in das Kristallgitter der SBT-Schicht 33 eingebaut wird. Dieser Prozeß benötigt wie eingangs genannt eine hohe Prozeßtemperatur und in der Regel eine relativ lange Behandlungszeit. Bei dieser langen Wärmebehandlungszeit kann der Sauerstoff auch durch die untere Elektrodenschicht 32 hindurchdringen. In diesem Fall kann der durchdringende Sauerstoff mit dem Titanmaterial der nach oben freiliegenden Abschnitte der Ti-Schicht 30 (eingekreiste Abschnitte in Fig.2B) oxidieren, so daß sich eine dünne, isolierende TiO-Schicht ausbildet. Da Titan sehr oxidationsfreudig ist, können schon relativ geringe Mengen an Sauerstoff für die Ausbildung dieser TiO-Schicht ausreichend sein. Damit werden jedoch die elektrischen Eigenschaften der Kontaktierungsstruktur deutlich verschlechtert, da der Durchgangskontakt nur noch auf einem verringerten Querschnitt elektrisch leitfähig ist.

In der Druckschrift WO 00/14796 A wird ein Verfahren zur Herstellung einer Kontaktierungsstruktur für die Kontaktierung eines Speicherkondensators mit einem Schalttransistor durch eine Isolationsschicht beschrieben. Dabei wird in einem in der Isolationsschicht geformten Kontaktloch ein elektrisch leitender Füllstopfen aus polykristallinem Silizium gebildet, der von der Oberfläche der Isolationsschicht zurückversetzt ist. Auf diesen Füllstopfen werden dann nacheinander eine erste Barrierenschicht aus Titan gegen die Diffusion von Silizium aus dem Füllstopfen in den Speicherkondensator und eine zweite Barrierenschicht gegen die Diffusion von Sauerstoff aus dem Speicherkondensator in Richtung auf den Füllstopfen abgeschieden. Oberhalb der zweiten Barrierenschicht werden dann die Schichten des Speicherkondensators nacheinander abgeschieden, wobei der Speicherkondensator sich teilweise in das Kontaktloch hinein erstreckt.

In der Druckschrift EP-A-0 991 117 wird eine Speicherzelle mit einem Auswahltransistor und einem Speicherkondensator beschrieben, bei der ein Anschlußgebiet des Schalttransistors durch einen in einer Isolationsschicht gebildeten leitfähigen Füllstopfen mit dem Speicherkondensator verbunden ist, der oberhalb des Füllstopfens in einer wannenförmigen Ausnehmung der Isolationsschicht ausgebildet ist.

Der vorliegenden Erfindung liegt somit die Aufgabe zugrunde, eine Kontaktierungsstruktur für einen ferroelektrischen Speicherkondensator und ein Verfahren zu ihrer Herstellung anzugeben, bei welchen die Kontaktierungsstruktur durch nachfolgende Schritte bei der Prozessierung des Speicherkondensators nicht in ihren Eigenschaften beeinträchtigt wird. Insbesondere liegt der Erfindung die Aufgabe zugrunde, eine bei der Herstellung der Kontaktierungsstruktur verwendete oxidierbare Zwischenschicht gegen das Eindringen von Sauerstoff zu schützen.

Diese Aufgabe wird durch die Merkmale der unabhängigen Patentansprüche gelöst. Vorteilhafte Weiterbildungen und Ausgestaltungen sind in den Unteransprüchen angegeben.

Die Erfindung beruht im wesentlichen darauf, daß die oxidierbare Zwischenschicht bereits nach dem Abscheiden der Sauerstoffbarrierenschicht vollständig von dem leitfähigen Material des Durchgangskontakts, der Isolationsschicht und der Barrierenschicht umgeben ist. In der Richtung des Durchgangskontakts grenzt die Zwischenschicht an den in der Kontaktlochöffnung befindlichen Füllstopfen aus leitfähigem Material, in lateraler Richtung ist die Zwischenschicht von der Isolationsschicht umgeben und in Richtung auf den zu formenden Speicherkondensator ist die Zwischenschicht von der Barrierenschicht umgeben. Sie ist somit auf solchen Abschnitten, auf denen sie nach den konventionellen Verfahren von der ferroelektrischen Schicht des Speicherkondensators nur noch durch die untere Elektrodenschicht getrennt ist, von der Sauerstoffbarrierenschicht umgeben. Damit wird erreicht, daß etwa bei dem Temperaturbehandlungsschritt der ferroelektrischen Schicht kein Sauerstoff zu der Zwischenschicht vordringen kann.

Ein Verfahren zur Herstellung einer Kontaktierungsstruktur für die Kontaktierung eines ferroelektrischen Speicherkondensators mit einem Schalttransistor ist durch die Merkmale des Patentanspruchs 6 angegeben.

Erfindungsgemäß (wird in dem Verfahrensschritt c) zunächst die Zwischenschicht derart abgeschieden, daß sie die Innenwand des oberen, nicht mit dem leitfähigen Material gefüllten Abschnitts der Kontaktlochöffnung bis auf einen oberen umlaufenden Randabschnitt bedeckt. Anschließend wird die Barrierenschicht in die Kontaktlochöffnung derart ausgebildet, dass sie mit der Isolationsschicht eine ebene Oberfläche formt. Bei letzterem kann die Barrierenschicht auch zunächst zum Teil auf der Oberfläche der Isolationsschicht abgeschieden werden. Sie kann von dort durch einen CMP-Prozeß wieder entfernt werden.

Eine bevorzugte Ausführungsform kann besonders vorteilhaft durchgeführt werden, indem im Verfahrensschritt c) die Zwischenschicht zunächst so abgeschieden wird, daß sie die Innenwand des oberen, nicht befüllten Abschnitts der Kontaktlochöffnung vollständig bedeckt, dann eine Photoresistschicht bis zu der Höhe der unteren Kante des vorgesehenen freizuhaltenden Randabschnitts in die Kontaktlochöffnung gefüllt wird der nicht von der Photoresistschicht bedeckte Abschnitt der Zwischenschicht durch einen Ätzschritt entfernt wird, und anschließend die Photoresistschicht entfernt wird.

Wie bereits im Zusammenhang mit dem Stand der Technik beschrieben, kann das leitfähige Material in der Kontaktlochöffnung durch dotiertes polykristallines Silizium gebildet sein. Als Sauerstoffbarrierenschicht kann eine Ir-Schicht oder eine IrO-Schicht oder eine aus beiden bestehende Doppelschicht verwendet werden und als Zwischenschicht kann eine Ti-Schicht, eine TiN-Schicht oder eine Ti/TiN-Doppelschicht eingesetzt werden. Die Erfindung ist aber nicht auf diese Materialien beschränkt und kann auch auf andere Fälle angewandt werden, in denen eine zwischen einer Barrierenschicht und dem leitfähigen Material einer Kontaktlochöffnung angeordnete oxidierbare Zwischenschicht vor dem Eindringen von Sauerstoff geschützt werden soll.

Das erfindungsgemäße Verfahren kann in ein Verfahren zum Herstellen eines den Speicherkondensator enthaltenden Speicherbauelements, insbesondere einer DRAM-Speicherzelle, eingebunden werden, wobei zunächst auf einem Substrat wie einem Halbleitersubstrat ein Schalttransistor geformt wird, auf dem Schalttransistor eine Isolationsschicht aufgebracht wird, die Isolationsschicht nach dem erfindungsgemäßen Verfahren mit einer Kontaktierungsstruktur versehen wird und schließlich auf der Kontaktierungsstruktur ein ferroelektrischer Speicherkondensator geformt wird.

Im folgenden wird ein einziges Ausführungsbeispiel der Erfindung anhand der Zeichnungen näher erläutert. Es zeigen:
- Fig.1: eine Querschnittsansicht einer konventionellen DRAM-Speicherzelle nach dem gestapelten Konzept
- Fig.2A,B: die konventionelle Herstellung der Kontaktierungsstruktur;
- Fig.3A-D: ein Ausführungsbeispiel für die erfindungsgemäße Herstellung der Kontaktierungsstruktur.

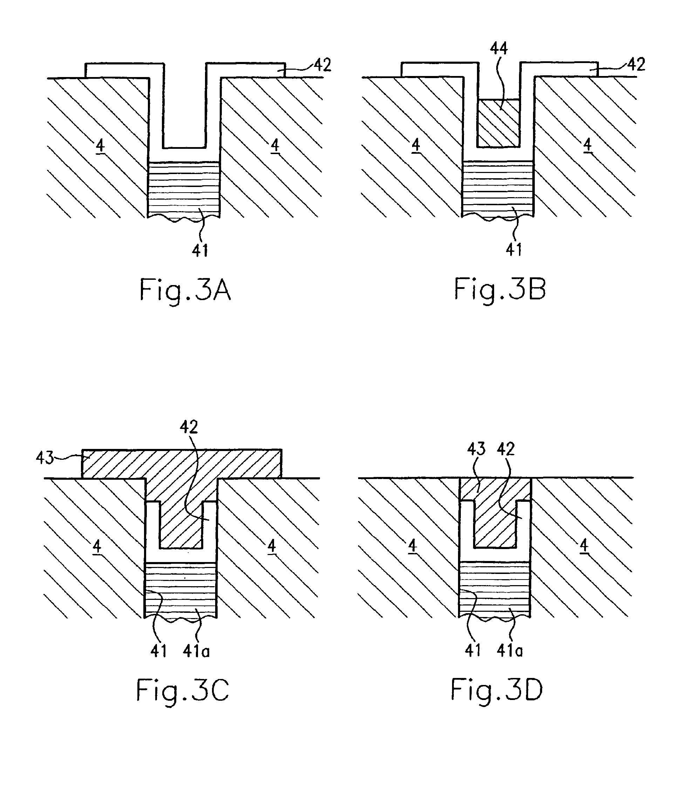

In der Fig.3A ist ein oberer Abschnitt des in die Isolationsschicht 4 geformten Kontaktlochs 41 im Querschnitt dargestellt, welches bis zu einer bestimmten Höhe mit dotiertem polykristallinem Silizium gefüllt ist. Dies wird meistens so hergestellt, daß das Kontaktloch 41 zunächst vollständig mit Poly-Silizium aufgefüllt wird und anschließend zum Teil durch einen Ätzschritt wieder entfernt wird. Dann wird eine Ti-, TiN- oder Ti/TiN-Doppelschicht 42 abgeschieden, so daß diese die Wände des Kontaktlochs 41 in diesem oberen Abschnitt auskleidet und einen Randabschnitt beidseits des Kontaktlochs 41 auf der oberen Oberfläche der Isolationsschicht 4 bedeckt.

Gemäß Fig.3B wird dann das Kontaktloch 41 bis zu einer bestimmten Höhe mit einer Photoresistschicht 44 gefüllt. Diese Photoresistschicht 44 dient als Maskierungsschicht für einen nachfolgenden Ätzschritt zur selektiven Entfernung der Zwischenschicht 42. In diesem Ätzschritt werden dann die von der Photoresistschicht 44 unbedeckten Abschnitte der Zwischenschicht 42 entfernt.

Nach der Entfernung dieser Abschnitte der Zwischenschicht 42 wird dann gemäß Fig.3C eine Sauerstoffbarrierenschicht 43 in die Kontaktlochöffnung und einen Oberflächenabschnitt der Isolationsschicht 4 abgeschieden. Dieser auf der Oberfläche der Isolationsschicht 4 überstehende Teil der Barrierenschicht 43 kann dann durch einen CMP-Prozeß entfernt werden, so daß die in Fig.3D gezeigte Struktur resultiert.

Durch Vergleich der Fig.3D mit der Fig.2B wird der Vorteil der Erfindung unmittelbar ersichtlich. Die Zwischenschicht 42 reicht nicht mehr bis an die Oberfläche der Struktur sondern ist um einen geringen Abstand in die Tiefe der Struktur zurückversetzt. Dieser Abstand wird durch die Höhe der gemäß Fig.3B abgeschiedenen Photoresistschicht 44 bestimmt. Durch diesen Abstand wird wirksam verhindert, daß Sauerstoffatome, die beispielsweise bei einem Temperprozeß an der ferroelektrischen Schicht in tiefere Regionen der Struktur diffundieren, in die Zwischenschicht 42 eindringen und an ihrer Oberfläche elektrisch isolierende Oxidschichten bilden.

Das dargestellte Ausführungsbeispiel hat den Vorzug, daß die Kontaktierungsstruktur in die Isolationsschicht 4 eingebettet ist und mit der Oberfläche der Isolationsschicht 4 eine planarisierte Struktur bildet. Dies erleichtert die anschließende Bildung des Speicherkondensators auf der Kontaktierungsstruktur.

Auf die Isolationsschicht 4 mit der Kontaktierungsstruktur wird dann eine erste untere beispielsweise aus Platin gebildete Elektrodenschicht 32 des zu formenden Speicherkondensators, abgeschieden. Auf die untere Elektrodenschicht 32 wird eine metalloxidhaltige Schicht 33 als Kondensatordielektrikum abgeschieden, die wie eingangs bereits beschrieben nunmehr einer Temperaturbehandlung in sauerstoffhaltiger Atmosphäre unterzogen werden kann, ohne daß es dabei zu einer nennenswerten Schädigung der Zwischenschicht 42 der Kontaktierungsstruktur kommt.

## Patentansprüche

1. Kontaktierungsstruktur für die Kontaktierung eines ferroelektrischen Speicherkondensators (3) mit einem Schalttransistor (2) durch eine Isolationsschicht (4), bei welcher
- in einer Isolationsschicht (4) eine Kontaktöffnung (41) geformt ist, die einen von der Oberfläche der Isolationsschicht (4) zurückversetzten Füllstopfen (41a) aus elektrisch leitfähigem Material enthält,
**dadurch gekennzeichnet, daß**
- in der Kontaktöffnung (41) oberhalb des Füllstopfens (41a) eine leitfähige, oxidierbare Zwischenschicht (42) in Form eines horizontalen Schichtabschnitts auf der horizontalen Oberfläche des Füllstopfens (41a) und daran angrenzend in Form von vertikalen Schichtabschnitten entlang den Seitenwänden der Kontaktöffnung (41) bis zu einer Höhe unterhalb der Oberfläche der Isolationsschicht (4) ausgebildet ist, so daß zwischen den vertikalen Schichtabschnitten ein Zwischenraum verbleibt,
- auf der Zwischenschicht (42) eine leitfähige Sauerstoffbarrierenschicht (43) in den Zwischenraum zwischen den vertikalen Schichtabschnitten der Zwischenschicht (42) und oberhalb der vertikalen Schichtabschnitte der Zwischenschicht (42) bis zu der Oberfläche der Isolationsschicht (4) ausgebildet ist, so daß die Sauerstoffbarrierenschicht (43) mit der Isolationsschicht (4) eine ebene Oberfläche bildet und die Zwischenschicht (42) vollständig von dem Füllstopfen (41a), der Isolationsschicht (4) und der Sauerstoffbarrierenschicht (43) umgeben ist.

2. Kontaktierungsstruktur nach Anspruch 1,
**dadurch gekennzeichnet, daß**
- die Zwischenschicht (42) eine Ti-Schicht, eine TiN-Schicht oder eine Ti/TiN-Doppelschicht enthält.

3. Kontaktierungsstruktur nach Anspruch 1 oder 2,
**dadurch gekennzeichnet, daß**
- die Barrierenschicht (43) eine Ir-Schicht oder eine IrO-Schicht enthält.

4. Kontaktierungsstruktur nach einem der vorhergehenden Ansprüche,
**dadurch gekennzeichnet, daß**
- das leitfähige Material des Füllstopfens (41a) polykristallines Silizium ist.

5. Speicherbauelement, mit
- einem auf einem Substrat (1) geformten Schalttransistor (2),
- einer auf dem Schalttransistor (2) aufgebrachten Isolationsschicht (4),
- einer in der Isolationsschicht (4) geformten Kontaktierungsstruktur nach einem der vorhergehenden Ansprüche,
- einem auf der Kontaktierungsstruktur geformten Speicherkondensator (3).

6. Verfahren zur Herstellung einer Kontaktierungsstruktur für die Kontaktierung eines ferroelektrischen Speicherkondensators (3) mit einem Schalttransistor (2) durch eine Isolationsschicht (4), bei welchem
a) in die Isolationsschicht (4) eine Kontaktöffnung (41) geformt wird;
b) die Kontaktöffnung (41) bis zu einer von der Oberfläche der Isolationsschicht (4) zurückversetzten Höhe mit einem Füllstopfen (41) aus elektrisch leitfähigem Material befüllt wird;
c) in der Kontaktöffnung (41) oberhalb des Füllstopfens (41a) eine leitfähige, oxidierbare Zwischenschicht (42) so abgeschieden wird, daß sie einen direkt an der Kontaktöffnung (41) angrenzenden Bereich der Oberfläche der Isolationsschicht (4), sowie die Innenwand des oberen, nicht mit dem leitfähigen Material gefüllten Abschnitts der Kontaktöffnung (41) vollständig bedeckt, und zumindest einen Teil der Oberfläche der Isolationsschicht (4) nicht bedeckt;
d) dann eine Photoresistschicht (44) bis zu einer bestimmten Höhe in die Kontaktöffnung (41) gefüllt wird;
e) der nicht von der Photoresistschicht (44) bedeckte Abschnitt der Zwischenschicht (42) durch einen Ätzschritt entfernt wird, und anschließend die Photoresistschicht (44) entfernt wird;
f) anschließend eine leitfähige Sauerstoff-Barrierenschicht (43) in die Kontaktöffnung und zum Teil auf einem direkt an der Kontaktöffnung (41) angrenzenden Bereich der Oberfläche der Isolationsschicht (4) derart abgeschieden wird, daß die Zwischenschicht (42) vollständig von dem Füllstopfen (41), der Isolationsschicht (4) und der SauerstoffBarrierenschicht (43) umgeben wird, und zumindest ein Teil der Oberfläche der Isolationsschicht (4) nicht von der Sauerstoff-Barrierenschicht (43) bedeckt wird;
g) die Sauerstoff-Barrierenschicht (43) von der Oberfläche der Isolationsschicht (4) durch einen Chemical-Mechanical-Polishing-Prozeß entfernt wird, sodaß die Sauerstoff-Barrierenschicht (43) mit der Isolationsschicht (4) eine ebene Oberfläche bildet;
wobei die Höhe, bis zu der die Photoresistschicht (44) in die Kontaktöffnung (41) nach dem Verfahrensschritt (d) gefüllt wird, so bestimmt wird, daß durch den im Verfahrensschritt e) beschriebenen Ätzschritt die Zwischenschicht (42) in Form eines horizontalen Schichtabschnitts auf der horizontalen Oberfläche des Füllstopfens (41a) und daran angrenzend in Form von vertikalen Schichtabschnitten entlang den Seitenwänden der Kontaktöffnung (41) bis zu einer Höhe unterhalb der Isolationsschicht (4) ausgebildet wird, sodaß zwischen den vertikalen Schichtabschnitten ein Zwischenraum verbleibt.

7. Verfahren nach Anspruch 6,
**dadurch gekennzeichnet, daß**
- die Zwischenschicht (42) eine Ti-Schicht, eine TiN-Schicht oder eine Ti/TiN-Doppelschicht enthält.

8. Verfahren nach Anspruch 6 oder 7,
**dadurch gekennzeichnet, daß**
- die Sauerstoff-Barrierenschicht (43) eine Ir-Schicht oder eine IrO-Schicht enthält.

9. Verfahren nach einem der Ansprüche 6 bis 8,
**dadurch gekennzeichnet, daß**
- das leitfähige Material in der Kontaktöffnung (41) polykristallines Silizium ist.

10. Herstellungsverfahren für ein Speicherbauelement, bei welchem
- auf einem Substrat (1) ein Schalttransistor (2) geformt wird,
- auf dem Schalttransistor (2) eine Isolationsschicht (4) aufgebracht wird,
- die Isolationsschicht (4) nach einem der vorhergehenden Ansprüche 6 bis 9 mit einer Kontaktierungsstruktur versehen wird, und
- auf der Kontaktierungsstruktur ein ferro- oder paraelektrischer Speicherkondensator (3) geformt wird.

## Claims

1. Contact-making structure for making contact between a ferroelectric storage capacitor (3) and a switching transistor (2) through an insulation layer (4), in which
- a contact opening (41) is formed in an insulation layer (4), which contact opening contains a plug (41a) of electrically conductive material which is set back from the surface of the insulation layer (4),
**characterized in that**
- in the contact opening (41), above the plug (41a), a conductive, oxidizable interlayer (42) in the form of a horizontal layer section is formed on the horizontal surface of the plug (41a) and, adjacent thereto, in the form of vertical layer sections along the side walls of the contact opening (41) to a height below the surface of the insulation layer (4), such that a space remains between the vertical layer sections,
- on the interlayer (42) a conductive oxygen barrier layer (43) is formed in the space between the vertical layer sections of the interlayer (42) and above the vertical layer sections of the interlayer (42) up to the surface of the insulation layer (4), such that the oxygen barrier layer (43) forms a flat surface with the insulation layer (4) and the interlayer (42) is completely surrounded by the plug (41a), the insulation layer (4) and the oxygen barrier layer (43).

2. Contact-making structure according to Claim 1,
**characterized in that**
- the interlayer (42) contains a Ti layer, a TiN layer or a Ti/TiN double layer.

3. Contact-making structure according to Claim 1 or 2, **characterized in that**
- the barrier layer (43) contains an Ir layer or an IrO layer.

4. Contact-making structure according to one of the preceding claims, **characterized in that**
- the conductive material of the plug (41a) is polycrystalline silicon.

5. Memory component, having
- a switching transistor (2) which is formed on the substrate (1),
- an insulation layer (4) which has been applied to the switching transistor (2),
- a contact-making structure formed in the insulation layer (4) according to one of the preceding claims,
- a storage capacitor (3) formed on the contact-making structure.

6. Method for fabricating a contact-making structure for making contact between a ferroelectric memory capacitor (3) and a switching transistor (2) through an insulation layer (4), in which
a) a contact opening (41) is formed into the insulation layer (4);
b) the contact opening (41) is filled with a plug (41) of electrically conductive material up to a height which is set back from the surface of the insulation layer (4);
c) in the contact opening (41) above the plug (41a) a conductive, oxidizable interlayer (42) is deposited in such a way that it completely covers a region of the surface of the insulation layer (4) that directly adjoins the contact opening (41) and also completely covers the inner wall of the upper section, which is not filled with the conductive material, of the contact opening (41), and does not cover at least part of the surface of the insulation layer (4);
d) then, a photoresist layer (44) is introduced into the contact opening (41) up to a certain height;
e) the section of the interlayer (42) which is not covered by the photoresist layer (44) is removed by an etching step, and then the photoresist layer (44) is removed;
f) then, a conductive oxygen barrier layer (43) is deposited in the contact opening and partly on a region of the surface of the insulation layer (4) that directly adjoins the contact opening (41), in such a manner that the interlayer (42) is completely surrounded by the plug (41), the insulation layer (4) and the oxygen barrier layer (43), and at least part of the surface of the insulation layer (4) is not covered by the oxygen barrier layer (43);
g) the oxygen barrier layer (43) is removed from the surface of the insulation layer (4) by a chemical mechanical polishing process, such that the oxygen barrier layer (43) forms a flat surface with the insulation layer (4);
wherein the height up to which the photoresist layer (44) is introduced into the contact opening (41) in accordance with method step (d) is determined in such a way that as a result of the etching step described in method step (e) the interlayer (42) is formed in the form of a horizontal layer section on the horizontal surface of the plug (41a) and, adjacent thereto, in the form of vertical layer sections along the side walls of the contact opening (41) up to a height below the insulation layer (4), such that a space remains between the vertical layer sections.

7. Method according to Claim 6, **characterized in that**
- the interlayer (42) contains a Ti layer, a TiN layer or a Ti/TiN double layer.

8. Method according to Claim 6 or 7, **characterized in that**
- the oxygen barrier layer (43) contains an Ir layer or an IrO layer.

9. Method according to one of Claims 6 to 8,
**characterized in that**
- the conductive material in the contact opening (41) is polycrystalline silicon.

10. Method for fabricating a memory component, in which
- a switching transistor (2) is formed on a substrate (1),
- an insulation layer (4) is applied to the switching transistor (2),
- the insulation layer (4) is provided, according to one of the preceding Claims 6 to 9, with a contact-making structure, and
- a ferroelectric or paraelectric storage capacitor (3) is formed on the contact-making structure.

## Revendications

1. Structure de mise en contact, pour la mise en contact d'un condensateur de mémoire (3) ferro-électrique avec un transistor (2) de commutation par une couche (4) isolante dans laquelle
- il est formé dans une couche (4) isolante une ouverture (41) de contact, qui contient un tampon (41a) de remplissage en matériau conducteur de l'électricité en retrait de la surface de la couche (4) isolante,
**caractérisée en ce que**
- dans l'ouverture (41) de contact au-dessus du tampon (41a) de remplissage est formée une couche (42) intermédiaire conductrice et oxydable sous la forme d'une partie de couche horizontale sur la surface horizontale du tampon (41a) de remplissage et, voisines de celle-ci, sous la forme de parties de couche verticales le long des parois latérales de l'ouverture (41) de contact jusqu'à un niveau en dessous de la surface de la couche (4) isolante, de sorte qu'il reste un espace intermédiaire entre les parties de couches verticales
- sur la couche (42) intermédiaire est formée une couche (43) conductrice de barrière à l'oxygène dans l'espace intermédiaire compris entre les parties de couches verticales de la couche (42) intermédiaire et au-dessus des parties de couches verticales de la couche (42) intermédiaire jusqu'à la surface de la couche (4) isolante, de sorte que la couche (43) de barrière à l'oxygène forme avec la couche (4) isolante une surface plane et la couche (42) intermédiaire est entourée complètement du tampon (41a) de remplissage, de la couche (4) isolante et de la couche (43) de barrière à l'oxygène.

2. Structure de mise en contact suivant la revendication 1,
**caractérisée en ce que**
- la couche (42) intermédiaire comporte une couche de Ti, une couche de TiN ou une couche double de Ti/TiN.

3. Structure de mise en contact suivant la revendication 1 ou 2,
**caractérisée en ce que**
- la couche (43) barrière contient une couche d'Ir ou d'IrO.

4. Structure de mise en contact suivant l'une des revendications précédentes,
**caractérisée en ce que**
- le matériau conducteur du tampon (41a) de remplissage est du silicium polycrstalin.

5. Composant de mémoire, comprenant
- un transistor (2) de commutation formé sur un substrat (1),
- une couche (4) isolante déposée sur le transistor (2) de commutation,
- une structure de mise en contact formée dans la couche (4) isolante suivant l'une des revendications précédentes,
- un condensateur (3) de mémoire formé sur la structure de mise en contact.

6. Procédé de production d'une structure de mise en contact pour la mise en contact d'un condensateur (3) de mémoire ferro-électrique avec un transistor (2) de commutation à travers une couche (4) isolante, dans lequel
a) on forme une ouverture (41) de contact dans la couche (4) isolante ;
b) on remplit l'ouverture (41) de contact jusqu'à un niveau en retrait de la surface de la couche (4) isolante avec un tampon (41a) de remplissage en matériau conducteur de l'électricité;
c) on dépose dans l'ouverture (41) de contact, au-dessus du tampon (41a) de remplissage, une couche (42) intermédiaire conductrice et oxydable de sorte qu'elle recouvre entièrement une partie directement voisine de l'ouverture (41) de contact de la surface de la couche (4) isolante, ainsi que la paroi intérieure de la partie supérieure, non remplie de matériau conducteur, de l'ouverture (41) de contact, et au moins une partie de la surface de la couche (4) isolante n'est pas recouverte;
d) on remplit ensuite l'ouverture (41) de contact d'une couche (44) de réserve photosensible jusqu'à un niveau déterminé ;
e) on élimine par un stade d'attaque la partie de la couche (42) intermédiaire qui n'est pas revêtue de la couche (44) de réserve de photosensible, et ensuite on élimine la couche (44) de réserve de photosensible ;
f) ensuite on dépose une couche (43) conductrice de barrière à l'oxygène dans l'ouverture de contact et en partie sur une région directement voisine de l'ouverture (41) de contact de la surface de la couche (44) isolante, de sorte que la couche (42) intermédiaire soit entièrement entourée du tampon (41) de remplissage, de la couche (4) isolante et de la couche (43) de barrière à l'oxygène, et on ne revêt pas de la couche (43) de barrière à l'oxygène au moins une partie de la surface de la couche (4) isolante ;
g) on élimine la couche (43) de barrière à l'oxygène de la surface de la couche (4) isolante par une opération Chemical-Mécanical-Polishing de manière à ce que la couche (43) de barrière à l'oxygène forme avec la couche (4) isolante une surface plane ;
le niveau jusqu'auquel on remplit l'ouverture (41) de contact de la couche de réserve photosensible suivant le stade (d) du procédé étant déterminé de façon à ce que par le stade d'attaque décrit au stade e) du procédé la couche (42) intermédiaire soit formée sous la forme d'une partie de couche horizontale sur la surface horizontale du tampon (41a) de remplissage et voisines de celles-ci sous la forme de parties de couche verticales le long des parois latérales de l'ouverture (41) de contact jusqu'à un niveau en dessous de la couche (4) isolante de manière à ce qu'il reste un espace intermédiaire entre les parties de couches verticales.

7. Procédé suivant la revendication 6, **caractérisé en ce que** la couche (42) intermédiaire comporte une couche de Ti, une couche de TiN ou une couche double de Ti/TiN.

8. Procédé suivant la revendication 6 ou 7, **caractérisé en ce que** la couche (43) barrière à l'oxygène contient une couche d'Ir ou d'IrO.

9. Procédé suivant l'une des revendications 6 à 8, **caractérisé en ce que** le matériau conducteur dans l'ouverture (41) de contact est du silicium polycristallin.

10. Procédé de production d'un composant de mémoire, dans lequel
- on forme un transistor (2) de commutation sur un substrat (1),
- on dépose une couche (4) isolante sur le transistor (2) de commutation,
- on munie la couche (4) isolante suivant l'une des revendications 6 à 9 précédentes d'une structure de mise en contact, et
- on forme un condensateur (3) de mémoire ferro-électrique ou para-électrique sur la structure de mise en contact.
